# EUROPÄISCHE PATENTSCHRIFT

(11) **EP 2 580 366 B1**
(45) Veröffentlichungstag und Bekanntmachung des Hinweises auf die Patenterteilung: **06.05.2020**
(21) Anmeldenummer: 11728579.1
(22) Anmeldetag: 23.05.2011
(51) Int. Cl.: C23C 14/08, C23C 14/16, C23C 14/32, B01J 37/02, C25B 11/04, B01J 23/46, B01J 21/06, C23C 14/02, C23C 14/00, B01J 37/14, B01J 37/34

(54) **VERFAHREN ZUR EIN- ODER MEHRSEITIGEN SUBSTRATBESCHICHTUNG**
PROCESS FOR SUBSTRATE COATING ON ONE OR MORE SIDES
PROCÉDÉ POUR REVÊTEMENT DE SUBSTRAT SUR UNE OU PLUSIEURS FACES

(30) Priorität: 11.06.2010 DE 102010023418
(43) Veröffentlichungstag der Anmeldung: 17.04.2013
(73) Patentinhaber: thyssenkrupp Industrial Solutions AG, 45143 Essen (DE)
(72) Erfinder: DULLE, Karl-Heinz, 59399 Olfen (DE); FUNCK, Frank, 46119 Oberhausen (DE); HOORMANN, Dirk, 59368 Werne an der Lippe (DE); OELMANN, Stefan, 58239 Schwerte-Ergste (DE); WOLTERING, Peter, 48485 Neuenkirchen (DE); SCHMITT, Carsten, 58091 Hagen (DE); HOFMANN, Philipp, 1180 Wien (AT); BÄUMER, Ulf-Steffen, 59423 Unna (DE)
(74) Vertreter: thyssenkrupp Intellectual Property GmbH
(86) Internationale Anmeldenummer: PCT/EP2011/002551
(87) Internationale Veröffentlichungsnummer: WO 2011/154094

(56) Entgegenhaltungen:
- EP-A1- 0 129 088
- EP-A1- 1 624 087
- DE-A1-102006 057 386
- US-A- 5 868 913
- US-A- 6 017 430

## Beschreibung

Die Erfindung betrifft ein Verfahren zur ein- oder mehrseitigen Substratbeschichtung mit katalytisch aktivem Material entsprechend Anspruch 1, umfassend eine Materialabscheidung unter Vakuum in einer Vakuumkammer, wobei die folgenden Schritte durchlaufen werden
(a) Beladung der Vakuumkammer mit mindestens einem Substrat,
(b) Verschluss und Evakuierung der Vakuumkammer,
(c) Substratreinigung durch Einleitung eines gasförmigen Reduktionsmittels in die Vakuumkammer,
(d) Entfernen des gasförmigen Reduktionsmittels,
(e) Aufbringen einer Zwischenschicht mittels Vakkuumbogenverdampfen, wobei ein Substrat gleiches oder ähnliches Material in die Vakuumkammer geleitet wird,
(f) Einstellen der Vakuumkammer auf eine Temperatur von150°C bis 400°C,
(g) Aufbringen einer Beschichtung mittels Vakuumbogenverdampfen, wobei mindestens ein Metall, genommen aus der Gruppe Ruthenium, Iridium, Titan und Mischungen davon in die Vakuumkammer geleitet werden, und über die gesamte Beschichtungszeit Sauerstoff zugeführt wird,
(h) in einem letzten Schritt die Vakuumkammer wieder geflutet wird und das beschichtete Substrat der Kammer entnommen wird,
wobei die vorgenannten Schritte und Übergänge von einem Schritt zu dem jeweiligen nächsten im Vakuum bei gegebenenfalls unterschiedlichen Drücken, die über ein Schutzgas eingestellt werden, durchgeführt werden.

Elektroden, die bei der Chlor-Alkali-Elektrolyse eingesetzt werden, müssen mit einer katalytisch aktiven Schicht überzogen werden. Diese Beschichtungen werden mittels bekannter Sprüh-, Tauch- oder mechanischer Auftragungsverfahren realisiert.

In der DE 3118320A1 wird zur Verbesserung der Elektrodenqualität vorgeschlagen, auf einen Träger aus einem elektrisch leitfähigen Werkstoff im Vakuum durch Zerstäuben, Aufdampfen oder Plasmaaufdampfen eine Mehrkomponentenlegierung aus wenigstens zwei verschiedenen Bestandteilen so aufgebracht, dass die Beschichtung amorph ist und über die gesamte zugängliche Oberfläche aktive Zentren aufweist. Diese Beschichtung kann aus einem Übergangsmetall wie Nickel, Vanadium, Titan, Chrom, Kobalt, Niob, Molybdän und Wolfram bestehen, das geringe Mengen von Edelmetallen, wie Ruthenium, Platin oder Palladium enthält. Die amorphe und aktive Beschaffenheit der Oberfläche wird durch Auslaugen oder Abdampfen von bei dem Beschichten ebenfalls mit aufgebrachten Elementen wie Lithium, Bor, Kohlenstoff, Stickstoff, Sauerstoff, Aluminium, Silicium, Zink und einer nachfolgenden Glühbehandlung erhalten.

Eine Substratbeschichtung bestehend aus Wolfram, Wolframcarbid oder Gemischen davon wird in der DE 3232809 A1 offenbart. Außerdem ist mindestens eines der Elemente Nickel, Kobalt, Chrom, Molybdän, Bor und Kohlenstoff enthalten. Die Abdichtung der porösen, aktiven Schicht gegenüber dem Substrat geschieht durch Imprägnieren mit einem säurefesten, Fluor enthaltenden Harz.

Eine bekannte Anodenbeschichtung ist beispielsweise aus der DE 1671422 A1 bekannt. Hier werden Titananoden beschrieben, die mit Oxiden aus der Gruppe der Platinmetalle und von passivierbaren Metallen enthaltenden Gemischen beschichtet sind, z.B. einem Gemisch aus 30 Mol.-% Rutheniumoxid und 70 Mol.-% Titanoxid.

Kathodenbeschichtungen aus metallischem Ruthenium, wobei eine den Trägerkörper umschließende Metallschicht durch galvanische Abscheidung oder durch ein CVD-Verfahren erzeugt wird, sind in der DE 2734084 A1 beschrieben.

Bei einem anderen Verfahren wird auf dem Trägerkörper durch elektrolytische Beschichtung oder durch thermische Zersetzung salzhaltiger Präzipitate eine rutheniumhaltige Schicht hergestellt. In der DE 2811472 A1 wird die Trägeroberfläche mit einer Rutheniumverbindung beschichtet, das Lösungsmittel anschließend verdampft und die Verbindung in einer nicht oxidierenden Atmosphäre zusetzt.

In der DE 3322169 C2 ist eine Kathodenbeschichtung eines Trägers beansprucht, wobei die Beschichtung ein Platinmetall enthaltende Schicht ist, und die Schicht aus mehreren Rutheniumoxid und Nickeloxid enthaltenden Teilschichten besteht und das Mengenverhältnis der Oxide in den einzelnen Teilschichten der Schicht verschieden ist.

Auch die DE 3344416 C2 offenbart ein Verfahren zur Herstellung einer Elektrode, die eine Beschichtung aus einer Mischung aus Rutheniumoxid und Nickeloxid besteht. Dabei wird ein Träger mit einer Rutheniumsalze und Nickel lösende Mittel enthaltende Lösung behandelt, wodurch sich ein Teil des im Träger vorhandenen Nickels löst und sich durch Verdampfen des Lösungsmittels auf dem Träger Ruthenium- und Nickelsalze abscheiden. Durch Erwärmen des Trägers in einer sauerstoffhaltigen Atmosphäre wird eine Beschichtung aus Rutheniumoxid und Nickeloxid erzeugt.

In WO95/05499 ist eine Methode offenbart zur Herstellung einer Elektrode aus einem Substrat aus Metall und einem Überzug aus mindestens einer äußeren Schicht aus einem elektrokatalytisch-aktiven Material, das eine Mischung aus Rutheniumoxid und einem NichtEdelmetall umfasst, wobei diese Mischung durch den "Physical Vapour Deposition Process" (PVD-Verfahren) aufgetragen wird. Eine vorherige Reinigung der Substratoberfläche wird ebenfalls vorgesehen, wobei als Methoden Sandstrahlen oder eine Säurebehandlung vorgeschlagen wird. Der Fachmann weiß, dass eine derartige Anbeizung der Oberfläche eine Wanderung durch Diffusion von ursprünglich im Substrat enthaltenen Bestandteilen in eine aufgebrachte Beschichtung bewirkt. Dadurch wird bewirkt, dass der Katalysator in der Beschichtung gleichmäßig verteilt, wodurch sich eine Mischung aus Beschichtungsbestandteilen und Substratbestandteilen einstellt.

Die DE 10 2006 057386 A1 offenbart ein "Physical Vapour Deposition Process" (PVD-Verfahren), wobei in einem ersten Schritt eine Vakuumkammer mit einem Substrat beladen wird. Nach der Evakuierung der Vakuumkammer erfolgt eine Substratreinigung, indem durch Einleiten ein gasförmiges Reduktionsmittel in die Vakuumkammer eingeleitet wird. Des Weiteren erfolgt eine Vergrößerung der Substratoberfläche mittels Abscheidung einer dampfförmigen Komponente auf der Substratoberfläche. Die Beschichtung erfolgt nach einem der bekannten Verfahren wie Plasmabeschichtungsverfahren, physikalischer Gasabscheidung, Sputterverfahren oder ähnlichem und kann sowohl aus ein oder mehreren Metallen oder deren Oxiden bestehen. Je nachdem wie das Verfahren durchgeführt wird, kann während der gesamten oder einem Teil der Beschichtungsdauer ein oxidierendes Gas in die Vakuumkammer geleitet werden, so dass vornehmlich Beschichtungen entstehen, die sowohl Metalle als auch deren Oxide enthalten.

Weiterer relevanter Stand der Technik ist in dem Patentdokument US 6,017,430 genannt.

Ausgehend vom zitierten Stand der Technik besteht ein weiterer Bedarf an einer Identifizierung verbesserter Elektrodenbeschichtungen, die weiter erniedrigte Zellspannungen aufweisen, um eine wirtschaftlichere Fahrweise zu gewährleisten. Die Bereitstellung eines einer alternativen Substratbeschichtung mit optimierten Eigenschaften hat sich die vorliegende Erfindung zur Aufgabe gemacht.

Überraschenderweise wurde nun gefunden, dass Beschichtungen, die auf der einen Seite weitestgehend frei von Substratbestandteilen sind und auf der anderen Seite zudem weitestgehend frei von nicht-oxidierten Metallen sind, sich positiv auf die Zellspannung einer Elektrolysezelle auswirken. Der Fachmann würde dies nicht erwarten, da wie eingangs gezeigt, im Stand der Technik absichtlich die Wanderung von Substratbestandteilen herbeigeführt wird, bzw. direkt Mischungen unterschiedlicher Zusammensetzung aufgetragen werden, die auch Substratbestandteile enthalten. Auch wird im Stand der Technik nirgendwo hervorgehoben, dass reine Metalldioxidschichten besonders positive Effekte auf die Zellspannung aufweisen.

Die Erfindung betrifft ein Verfahren zur ein- oder mehrseitigen Substratbeschichtung mit katalytisch aktivem Material nach Anspruch 1, umfassend eine Materialabscheidung unter Vakuum in einer Vakuumkammer, wobei die folgenden Schritte durchlaufen werden
(a) Beladung der Vakuumkammer mit mindestens einem Substrat,
(b) Verschluss und Evakuierung der Vakuumkammer,
(c) Substratreinigung durch Einleitung eines gasförmigen Reduktionsmittels in die Vakuumkammer,
(d) Entfernen des gasförmigen Reduktionsmittels,
(e) Aufbringen einer Zwischenschicht mittels Vakuumbogenverdampfen, wobei ein Substrat gleiches oder ähnliches Material in die Vakuumkammer geleitet wird,
(f) Einstellen der Vakuumkammer auf eine Temperatur von150°C bis 400°C,
(g) Aufbringen einer Beschichtung mittels Vakuumbogenverdampfen , wobei mindestens ein Metall, genommen aus der Gruppe Ruthenium, Iridium, Titan und Mischungen davon in die Vakuumkammer geleitet werden, und über die gesamte Beschichtungszeit Sauerstoff zugeführt wird,
(h) in einem letzten Schritt die Vakuumkammer wieder geflutet wird und das beschichtete Substrat der Kammer entnommen wird,
wobei die vorgenannten Schritte und Übergänge von einem Schritt zu dem jeweiligen nächsten im Vakuum bei gegebenenfalls unterschiedlichen Drücken, die über ein Schutzgas eingestellt werden, durchgeführt werden, wobei die ein- oder mehrseitige Substratbeschichtung zu mindestens 99 % von ursprünglich im Substrat selbst enthaltenen Bestandteilen freigehalten wird, wobei die auf der Zwischenschicht aufgetragene Beschichtung zu mindestens 99 % von nicht-oxidierten Metallen freigehalten wird.

Dabei wird die Zwischenschicht, die in Verfahrensschritt (e) generiert wird, bevorzugt aus Metallen, genommen aus der Gruppe Ruthenium, Iridium, Titan und Mischungen davon gebildet. Eine weitere vorteilhafte Verfahrensweise ist, dass die Sauerstoffzufuhr des Verfahrensschritt (g) in gepulster Form erfolgt.

In bevorzugter Ausführungsform der Erfindung wird die Substratbeschichtung vollständig von ursprünglich im Substrat enthaltenen Bestandteilen freigehalten, sowie die auf der Zwischenschicht aufgetragene Beschichtung wird vollständig von nicht-oxidierten Metallen freigehalten. D.h. bei der Durchführung des Verfahrens wird durch die einzelnen Verfahrensschritte die Wanderung von ursprünglich im Substrat selbst enthaltenen Bestandteilen in die aufgebrachten Schichten unterbunden. Außerdem wird soviel Sauerstoff zugeführt, dass es sich um eine reine Metalloxidschicht handelt, die aufgebracht wird. Auf diese Weise wird eine Mischung aus Metall/Metalloxid und Substratbestandteilen in der äußeren Beschichtung vermieden.

Unter dem Ausdruck "vollständig frei" wird dabei verstanden, dass dies im Rahmen der technischen Nachweisgrenzen der gegebenen im Stand der Technik bekannten Messmethodiken zu verstehen ist. Die Bestimmung der technischen Merkmale des kennzeichnenden Teils des Hauptanspruchs wurde mittels XPS Spektroskopie (XPS System von Physical Electronics (PHI 5800 ESCA SYSTEM)) nachgewiesen.

Bei dem Verfahren, nach dem die Substratbeschichtung hergestellt werden soll, können die vorgenannten Schritte und Übergänge von einem Schritt zu dem jeweiligen nächsten im Vakuum bei gegebenenfalls unterschiedlichen Drücken durchgeführt werden. Somit verlässt das Substrat zu keinem Zeitpunkt das Vakuum und die Bildung von oxidischen Zwischenschichten oder eine erneute Schmutzanlagerung wird wirksam unterbunden. Weiterhin kann mittels des vorgenannten Abscheideverfahrens unter Vakuum jederzeit reproduzierbar eine gleichwertige Substratoberfläche geschaffen werden.

Überraschenderweise wurde festgestellt, dass die Einstellung der Temperatur auf Werte zwischen 150°C und 400°C bei der Beschichtung in Gegenwart von Sauerstoff sich positiv auf die Reaktion von elementarem Ruthenium mit Sauerstoff auswirkt und die Ausbildung von Beschichtungen, die weitestgehend frei von nicht-oxidierten Metallen sind und die erfindungsgemäß dafür vorgesehen sind auf die Zwischenschicht aufgebracht zu werden, positiv beeinflusst wird.

Zur Aufbringung der Beschichtung wird das Vakuumbogenverfahren angewandt. Überrachenderweise hat sich gezeigt, dass sich dieses Verfahren zur Herstellung reiner Metalldioxidschichten besonders gut eignet. Dabei findet ein lokales Verdampfen in den Kathodenbrennflecken eines Lichtbogens statt, der im selbst erzeugten Dampf brennt. Aus dem Stand der Technik ist bekannt, dass sich dieses Verfahren durch eine hohe Abscheidungsrate von ca. 100 nm/min auszeichnet. Diese Methode wird beispielsweise in der US 5317235 beschrieben. Hier wird eine Lichtbogenmetallabscheidungsvorrichtung offenbart, die verhindert, dass Metallkügelchen mit Metallionen abgeschieden werden.

Bevorzugt wird das Substrat ausgewählt aus einer Gruppe umfassend Edelstahl und Elemente der Nickel-Gruppe, sowie beschichtetem Edelstahl aus Elementen der Nickel-Gruppe.

Vorteilhaft besteht die auf der Zwischenschicht aufgetragene Beschichtung aus Rutheniumdioxid. Optional ist diese Beschichtung aus einer Mischung aus den Metalloxiden Rutheniumdioxid : Iridiumdioxid : Titandioxid zusammengesetzt.

Bevorzugt weist die erfindungsgemäße Zwischenschicht auf ihrer Oberfläche Unebenheiten auf. Dadurch kommt es zur Oberflächenvergrößerung des Substrates, was durch eine Abscheidung einer dampfförmigen Komponente erreicht wird. Dabei ist das aufzubringende Material idealerweise identisch mit dem Material des Substrats. Derartige Unebenheiten können auch in der auf der Zwischenschicht aufgebrachten Beschichtung vorhanden sein.

Das bekannte Verfahren des Vakuumverdampfens bietet den großen Vorteil, dass die Oberfläche nicht überdeckt wird und somit die vorhandene, gewünschte Rauhigkeit nicht wieder egalisiert wird, sondern inselartige, punktuelle Erhebungen geschaffen werden, die eine reale Oberflächenvergrößerung darstellen und an denen die nachfolgende eher flächige Schicht hervorragend haftet.

Vorteilhaft weist die Substratbeschichtung, bestehend aus einer Zwischenschicht und einer darauf aufgebrachten Beschichtung, eine Schichtdicke von 1 bis 50 µm, bevorzugt von 1 bis 30 µm, besonders bevorzugt von 1 bis 10 µm und am bevorzugsten von 1,5 bis 2,5 µm auf.

Das Verfahren kann dahingehend verbessert werden, dass dem Beschichtungsschritt (g) oder dem Entnahmeschritt (h) nachfolgend eine thermische Behandlung der beschichteten Substrate bei einer Temperatur von 350°C bis 650°C vorgenommen wird. Diese thermische Behandlung, bei welcher hier nicht näher zu beschreibende interkristalline Prozesse ablaufen, verbessert die Haftungsdauer der Beschichtung langfristig.

Das erfindungsgemäße Verfahren kann zudem dahingehend ergänzt werden, dass unter atmosphärischen Bedingungen und vor dem ersten Schritt (a) ein oder mehrere Verfahrensschritte zur Oberflächenvergrößerung, Profilierung und/oder Reinigung der Oberfläche vorgenommen werden. Idealerweise werden dabei mechanische Verfahren, wie beispielsweise ein Sandstrahlverfahren und/oder ein chemisches Verfahren, wie beispielsweise ein Ätzverfahren, eingesetzt. Im Anschluss erfolgt je nach vorheriger Behandlung eine erste Reinigung und/oder Trocknung der Substratoberfläche.

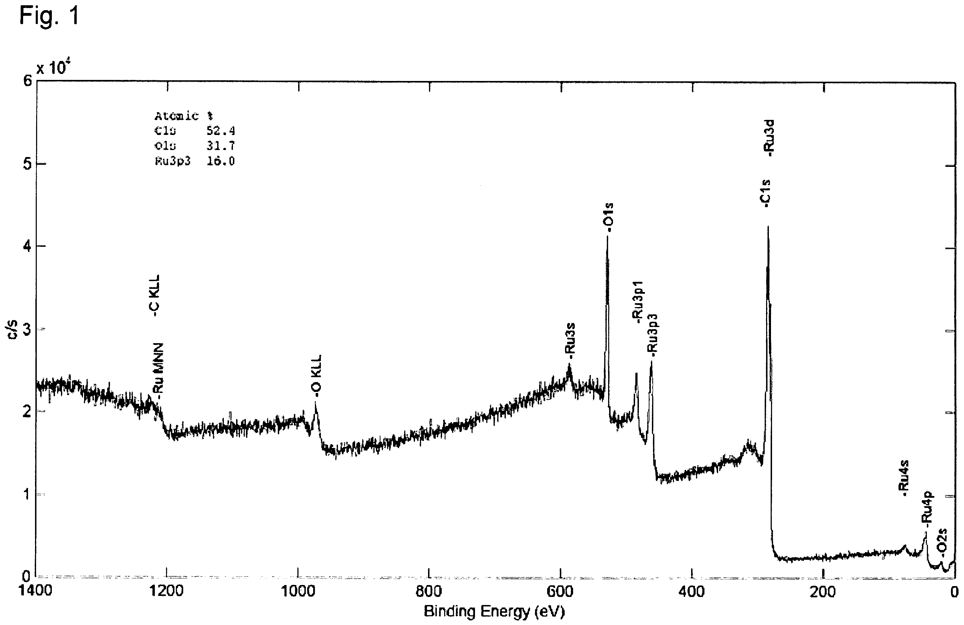

Die vorliegende Erfindung soll nachfolgend anhand von Fig. 1 detailliert erläutert werden. Es zeigt:
- Fig. 1:: XPS-Spektrum einer erfindungsgemäßen Kathodenbeschichtung

In einem Versuch wurde eine 2,7 m² große Nickel-Kathode, wie sie in der WO 98/15675 A1 beschrieben ist, als Substrat in eine Vakuumkammer eingebracht. In der Kammer wurde das Substrat mit einem Argon / Wasserstoff-Gemisch beaufschlagt und so vorgereinigt. In einem ersten Schritt wurde die Kammer evakuiert (10⁻⁵ bar). Anschließend die Oxidschicht reduziert, indem bei 250 - 350 °C Wasserstoff eingeleitet wurde. Nachfolgend wurde eine Oberflächenvergrößerung vorgenommen. Als Stoffquelle diente elementares Nickel, welches dem Werkstoff des Substrates entsprach. Dieses Nickel wurde als Zwischenschicht mittels Vakuumbogenverdampfen bei ∼10⁻⁵-bar Vakuum und einer Kammertemperatur von 250 - 350 °C auf dem Substrat abgeschieden, bis eine ~50-fache Oberflächenvergrößerung erreicht war.

Anschließend wurde auf die Zwischenschicht mittels Vakuumbogenverdampfen eine Beschichtung aus Rutheniumdioxid aufgetragen, wobei über die gesamte Beschichtungszeit Sauerstoff gepulst in die Vakuumkammer geleitet wurde. Dabei wurde bei einer Temperatur von 300 °C gearbeitet. Auf diese Weise wurde erwartungsgemäß in situ dargestelltes Rutheniumdioxid auf der Zwischenschicht abgeschieden, wie in der WO 08/067899 A1 offenbart.

Dadurch entsteht eine Substratbeschichtung, die, wie in Fig. 1 mittels eines XPS Spektrums gezeigt, frei ist von Substratbestandteilen. D.h. durch die schonende Methodik des Auftragens wird eine Wanderung der Substratbestandteile in die Substratbeschichtung unterbunden. Außerdem besteht die auf der Zwischenschicht aufgebrachte Beschichtung vollständig aus Rutheniumdioxid und ist nicht mit nicht-oxidiertem Substrat verunreinigt.

Überraschenderweise wurde nun gefunden, dass sich diese spezielle Substratbeschichtung, umfassend eine metallische Zwischenschicht und eine Beschichtung, die sowohl frei von Substratbestandteilen als auch frei von nicht-oxidierten Metallen ist, und die aus einer Vielzahl möglicher Beschichtungen, die von der WO 08/067899 abgedeckt werden, ausgewählt werden muss, besonders positiv auf die Zellspannung auswirkt. Der Fachmann würde dies nicht erwarten, da wie eingangs gezeigt, im Stand der Technik absichtlich die Wanderung von Substratbestandteilen herbeigeführt wird, bzw. direkt Mischungen unterschiedlicher Zusammensetzung aufgetragen werden, die auch Substratbestandteile enthalten.

Als Vergleichsversuch wurden Kathoden eingesetzt, die grundsätzlich nach dem oben beschriebenen Verfahren hergestellt worden sind. Allerdings wurde bei der Beschichtung mit Ruthenium auf die Einleitung von Sauerstoff verzichtet. Hierzu wurde Ruthenium über 2 min auf dem Substrat abgeschieden und erst anschließend erfolgte eine Nachoxidation zu Rutheniumdioxid, indem Sauerstoff eingeleitet wurde. Dadurch kann allerdings keine vollständig reine Rutheniumdioxidschicht erreicht werden. Die Beschichtung besteht vielmehr aus einer Mischung aus Rutheniumdioxid und elementarem Ruthenium.

Außerdem wurden kommerziell erhältliche Kathoden eingesetzt, die nach dem in der DE 3322169 C2 und dem in der DE 334416 C2 offenbarten Stand der Technik zugänglich sind.

Zur Versuchsdurchführung wurde ein Elektrolyseur mit 15 Elementen im 2,7 m² Maßstab ausgestattet. Dabei kamen jeweils 15 Anoden des gleichen Typs (C-Profil), 15 Membranen des Typs N2030 und 11 Kathoden mit kommerzieller Beschichtung, d.h. entweder nach der DE 3322169 C2, oder nach der DE 334416 C2 oder nach der WO08/067899 und 4 Kathoden, die mit der erfindungsgemäßen Beschichtung ohne Substratbestandteile und ohne nicht-oxidierte Metalle ausgestattet waren, zum Einsatz.

Betrieben wurde die Anlage anodenseitig mit 205 g/l NaCI-Lösung und kathodenseitig mit 32 Gew.-% Natronlauge. Der Elektrolyseur wurde bei einer Stromdichte von 6 kA/m² und einer Temperatur von 88°C über eine Laufzeit von 75 DOL betrieben. Nach 50 DOL war im Bezug auf die Zellspannung ein stationärer Betrieb erreicht.

Überraschenderweise konnte bei den 4 mit der erfindungsgemäßen Substratbeschichtung ausgestatteten Elementen gegenüber den 11 Elementen mit der jeweils gewählten kommerziellen Beschichtung eine um 30 mV geringere Zellspannung (standardisiert auf 90°C, 32 Gew.-% NaOH und 6 kA/m²) erzielt werden, was eine weitaus wirtschaftlichere Betriebsweise der Elektrolyseure mit sich bringt.

## Patentansprüche

1. Verfahren zur ein- oder mehrseitigen Beschichtung eines Substrats mit katalytisch aktivem Material,
umfassend eine Materialabscheidung unter Vakuum in einer Vakuumkammer, wobei die folgenden Schritte durchlaufen werden
(a) Beladung der Vakuumkammer mit mindestens einem Substrat,
(b) Verschluss und Evakuierung der Vakuumkammer,
(c) Substratreinigung durch Einleitung eines gasförmigen Reduktionsmittels in die Vakuumkammer,
(d) Entfernen des gasförmigen Reduktionsmittels,
(e) Aufbringen einer Zwischenschicht, wobei ein Material, welches gleich dem Material ist, aus dem das Substrat besteht, in die Vakuumkammer geleitet wird,
(f) Einstellen der Vakuumkammer auf eine Temperatur von150°C bis 400°C,
(g) Aufbringen einer weiteren Beschichtung auf die Zwischenschicht, wobei mindestens ein Metall, genommen aus der Gruppe Ruthenium, Iridium, Titan und Mischungen davon in die Vakuumkammer geleitet werden, und über die gesamte Beschichtungszeit Sauerstoff zugeführt wird,
(h) in einem letzten Schritt die Vakuumkammer wieder geflutet wird und das beschichtete Substrat der Kammer entnommen wird,
wobei die vorgenannten Schritte und Übergänge von einem Schritt zu dem jeweiligen nächsten im Vakuum bei gegebenenfalls unterschiedlichen Drücken, die über ein Schutzgas eingestellt werden, durchgeführt werden,
**dadurch gekennzeichnet, dass** das Aufbringen der Zwischenschicht in Schritt (e) und das Aufbringen der weiteren Beschichtung in Schritt (g) auf die Zwischenschicht jeweils mittels Vakuumbogenverdampfen erfolgen,
wobei die ein- oder mehrseitige weitere Beschichtung zu mindestens 99 % frei von ursprünglich im Substrat selbst enthaltenen Bestandteilen ist und wobei die auf die Zwischenschicht aufgetragene weitere Beschichtung zu mindestens 99 % frei von nicht-oxidierten Metallen ist.

2. Verfahren nach Anspruch 1, **dadurch gekennzeichnet, dass** die weitere Beschichtung vollständig frei von ursprünglich im Substrat selbst enthaltenen Bestandteilen ist, sowie die auf der Zwischenschicht aufgetragene weitere Beschichtung vollständig frei von nicht-oxidierten Metallen ist.

3. Verfahren nach einem der Ansprüche 1 oder 2, **dadurch gekennzeichnet, dass** das Substrat ausgewählt wird aus einer Gruppe umfassend Edelstahl und Elemente der Nickel-Gruppe, sowie beschichtetem Edelstahl aus Elementen der Nickel-Gruppe.

4. Verfahren nach einem der vorstehenden Ansprüche, **dadurch gekennzeichnet, dass** die auf der Zwischenschicht aufgetragene weitere Beschichtung aus Rutheniumdioxid besteht.

5. Verfahren nach einem der Ansprüche 1 bis 3, **dadurch gekennzeichnet, dass** die auf der Zwischenschicht aufgetragene weitere Beschichtung aus einer Mischung aus den Metalloxiden Rutheniumdioxid : Iridiumdioxid : Titandioxid zusammengesetzt ist.

6. Verfahren nach einem der vorstehenden Ansprüche, **dadurch gekennzeichnet, dass** die Zwischenschicht auf ihrer Oberfläche Unebenheiten aufweist.

7. Verfahren nach einem der vorstehenden Ansprüche, **dadurch gekennzeichnet, dass** die auf der Zwischenschicht aufgetragene weitere Beschichtung auf ihrer Oberfläche Unebenheiten aufweist.

8. Verfahren nach einem der vorstehenden Ansprüche, **dadurch gekennzeichnet, dass** die gesamte Substratbeschichtung, umfassend eine Zwischenschicht und eine darauf aufgebrachte weitere Beschichtung, eine Schichtdicke von 1 bis 50 µm, bevorzugt von 1 bis 30 µm, besonders bevorzugt von 1 bis 10 µm und am bevorzugsten von 1,5 bis 2,5 µm aufweist.

## Claims

1. Process for coating a substrate with catalytically active material on one or more sides,
comprising deposition of material under reduced pressure in a vacuum chamber, with the following steps being carried out
(a) loading of the vacuum chamber with at least one substrate,
(b) closure and evacuation of the vacuum chamber,
(c) cleaning of the substrate by introduction of a gaseous reducing agent into the vacuum chamber,
(d) removal of the gaseous reducing agent,
(e) application of an intermediate layer, with a material which is identical to the material of which the substrate consists being introduced into the vacuum chamber,
(f) setting of the vacuum chamber to a temperature of from 150°C to 400°C,
(g) application of a further coating on top of the intermediate layer, with at least one metal selected from the group consisting of ruthenium, iridium, titanium and mixtures thereof being introduced into the vacuum chamber and oxygen being fed in during the entire coating time,
(h) in a last step, the vacuum chamber is flooded again and the coated substrate is taken from the chamber,
where the abovementioned steps and transitions from one step to the respective next step are carried out under reduced pressure at optionally different pressures which are set by means of a protective gas,
**characterized in that** the application of the intermediate layer in step (e) and the application of the further coating in step (g) on top of the intermediate layer are each carried out by means of vacuum arc deposition,
where the further coating on one or more sides is at least 99% free of constituents originally present in the substrate itself and the further coating applied on top of the intermediate layer is at least 99% free of unoxidized metals.

2. Process according to Claim 1, **characterized in that** the further coating is completely free of constituents originally present in the substrate itself, and the further coating applied on top of the intermediate layer is completely free of unoxidized metals.

3. Process according to either of Claims 1 and 2, **characterized in that** the substrate is selected from the group consisting of stainless steel and elements of the nickel group and also coated stainless steel comprising elements of the nickel group.

4. Process according to any of the preceding claims, **characterized in that** the further coating applied on top of the intermediate layer consists of ruthenium dioxide.

5. Process according to any of Claims 1 to 3, **characterized in that** the further coating applied on top of the intermediate layer is composed of a mixture of the metal oxides ruthenium dioxide : iridium dioxide : titanium dioxide.

6. Process according to any of the preceding claims, **characterized in that** the intermediate layer has unevennesses on its surface.

7. Process according to any of the preceding claims, **characterized in that** the further coating applied on top of the intermediate layer has unevennesses on its surface.

8. Process according to any of the preceding claims, **characterized in that** the total substrate coating comprising an intermediate layer and a further coating applied on top of this has a layer thickness of from 1 to 50 µm, preferably from 1 to 30 µm, particularly preferably from 1 to 10 µm and most preferably from 1.5 to 2.5 µm.

## Revendications

1. Procédé pour le revêtement d'un ou de plusieurs côtés d'un substrat avec un matériau catalytiquement actif,
comprenant un dépôt de matériau sous vide dans une chambre sous vide, les étapes suivantes étant réalisées :
(a) le chargement de la chambre sous vide avec au moins un substrat,
(b) la fermeture et l'évacuation de la chambre sous vide,
(c) le nettoyage du substrat par acheminement d'un réducteur gazeux dans la chambre sous vide,
(d) l'élimination du réducteur gazeux,
(e) l'application d'une couche intermédiaire, un matériau qui est identique au matériau dont le substrat est constitué étant acheminé dans la chambre sous vide,
(f) l'ajustement de la chambre sous vide à une température de 150 °C à 400 °C,
(g) l'application d'un revêtement supplémentaire sur la couche intermédiaire, au moins un métal, pris dans le groupe constitué par le ruthénium, l'iridium, le titane et leurs mélanges, étant acheminé dans la chambre sous vide, et de l'oxygène étant introduit pendant la totalité du temps de revêtement,
(h) dans une dernière étape, la chambre sous vide est de nouveau noyée et le substrat revêtu est sorti de la chambre,
les étapes susmentionnées et les transitions d'une étape à la suivante étant réalisées sous vide à des pressions éventuellement différentes, qui sont ajustées par un gaz protecteur,
**caractérisé en ce que** l'application de la couche intermédiaire à l'étape (e) et l'application du revêtement supplémentaire à l'étape (g) sur la couche intermédiaire ont chacune lieu par évaporation à arc sous vide,
le revêtement supplémentaire d'un ou de plusieurs côtés étant à hauteur d'au moins 99 % exempt de constituants contenus eux-mêmes initialement dans le substrat et le revêtement supplémentaire appliqué sur la couche intermédiaire étant à hauteur d'au moins 99 % exempt de métaux non oxydés.

2. Procédé selon la revendication 1, **caractérisé en ce que** le revêtement supplémentaire est entièrement exempt de constituants contenus eux-mêmes initialement dans le substrat, et le revêtement supplémentaire appliqué sur la couche intermédiaire est entièrement exempt de métaux non oxydés.

3. Procédé selon l'une quelconque des revendications 1 ou 2, **caractérisé en ce que** le substrat est choisi dans un groupe comprenant l'acier inoxydable et les éléments du groupe du nickel, ainsi que l'acier inoxydable revêtu constitué d'éléments du groupe du nickel.

4. Procédé selon l'une quelconque des revendications précédentes, **caractérisé en ce que** le revêtement supplémentaire appliqué sur la couche intermédiaire est constitué par du dioxyde de ruthénium.

5. Procédé selon l'une quelconque des revendications 1 à 3, **caractérisé en ce que** le revêtement supplémentaire appliqué sur la couche intermédiaire est composé par un mélange des oxydes métalliques dioxyde de ruthénium : dioxyde d'iridium : dioxyde de titane.

6. Procédé selon l'une quelconque des revendications précédentes, **caractérisé en ce que** la couche intermédiaire présente des inégalités sur sa surface.

7. Procédé selon l'une quelconque des revendications précédentes, **caractérisé en ce que** le revêtement supplémentaire appliqué sur la couche intermédiaire présente des inégalités sur sa surface.

8. Procédé selon l'une quelconque des revendications précédentes, **caractérisé en ce que** la totalité du revêtement de substrat, comprenant une couche intermédiaire et un revêtement supplémentaire appliqué sur celle-ci, présente une épaisseur de couche de 1 à 50 µm, de préférence de 1 à 30 µm, de manière particulièrement préférée de 1 à 10 µm, et de manière préférée entre toutes de 1,5 à 2,5 µm.
